# EUROPEAN PATENT APPLICATION

(11) **EP 0 637 131 A1**
(43) Date of publication of application: **01.02.1995**
(21) Application number: 94111640.2
(22) Date of filing: 26.07.1994
(51) Int. Cl.: H03H 11/30

(54) **Microwave amplifier having a variable-impedance impedance matching circuit**

(30) Priority: 29.07.1993 JP 205576/93
(71) Applicant: NEC CORPORATION, Tokyo (JP)
(72) Inventor: Fujita, Masanori, Minato-ku, Tokyo (JP)
(74) Representative: Glawe, Delfs, Moll & Partner

(57) **Abstract**

A high efficiency microwave amplifier includes a variable-impedance impedance matching circuit (43) for the amplifier. The variable impedance is controlled from the outside to provide a maximum power efficiency at a transmission frequency to be used in the amplifier. The microwave amplifier is used in a portable telephone system to provide a maximum power efficiency at any transmission frequency allocated by a base station within a predetermined frequency band. The deviation in power efficiency is controlled within 1 dB over the frequency band to be used in the telephone system, resulting in a continuous long-period operation of the portable telephone system.

## Description

### BACKGROUND OF THE INVENTION

### (a) Field of the Invention:

The present invention relates to a microwave amplifier having a variable-impedance impedance matching circuit and, more particularly, to a microwave amplifier capable of amplifying a microwave signal with a high efficiency by varying a load impedance of the microwave amplifier in accordance with the frequency of the input thereof.

### (b) Description of the Related Art:

A high efficiency microwave amplifier for amplifying microwave signal with a high efficiency is widely used in a developing portable telephone system. A conventional high efficiency microwave amplifier used in a portable telephone system generally comprises an impedance matching circuit or load matching circuit having an optimal fixed impedance, regardless of the frequency of a transmission signal, to obtain a desired characteristic over the frequency band to be used in the telephone system.

In a high efficiency microwave amplifier used in a portable telephone system, the efficiency of each component thereof is made as close as its maximum. As a result, the conventional microwave amplifiers have only narrow band characteristics, hence, they have a problem that their output characteristics are not flat over the frequency band to be used, even when the input and output impedances thereof are set at a fixed value. Accordingly, the conventional high efficiency microwave amplifier produces some extent of deviation in output characteristic within the frequency band to be used, resulting in a significant excess power consumption.

### SUMMARY OF THE INVENTION

In view of the foregoing, an object of the present invention is to provide a microwave amplifier having an improved power efficiency.

Another object of the present invention is to provide a portable telephone system comprising a high efficiency microwave amplifier having a variable load impedance, thereby realizing a reduction of the power consumption in the portable telephone system over a predetermined band of the telephone system.

The present invention provides, in a first aspect thereof, a microwave amplifier comprising an amplifying means for amplifying a microwave signal, an impedance matching circuit having a variable impedance operatively connected to the output of the amplifying means, a control means for providing to the impedance matching circuit a control signal for varying said variable impedance in accordance with the frequency of the microwave signal.

The present invention also provides, in a second aspect thereof, a potable telephone system comprising: a signal generating section for generating a microwave signal having a frequency within a predetermined frequency band; an amplifier for amplifying the microwave signal; an impedance matching circuit operatively connected to the output of the amplifier and having a variable impedance; and a control section for selecting the frequency of the microwave signal and providing a control signal to the impedance matching circuit for varying the variable impedance in accordance with the frequency selected by the control section.

The microwave amplifier of the present invention can decrease the deviation in the output characteristic within the frequency band caused by a divergence in the load impedance of the amplifier within the frequency band to be used, thereby realizing a flat output characteristic and a high power efficiency over the frequency band to be used.

In a preferred embodiment of the first aspect of the present invention, the impedance matching circuit for the output of the microwave amplifier is controlled by a DC control voltage supplied from the outside to change the frequency at which the power efficiency of the amplifier is maximized within a predetermined frequency band, without deteriorating the harmonic characteristic and the distortion characteristic such as the transmission IM of the amplifier.

In a preferred embodiment of the second aspect of the present invention, a portable telephone system comprises the microwave amplifier as described above in the transmission section of the portable telephone system. The portable telephone system controls a control voltage supplied to the impedance matching circuit for the output of the amplifier such that the power efficiency of the amplifier is maximized at a transmission frequency used or allocated by a base station during operation of the portable telephone system. Preferably, data on the DC control voltages corresponding to the frequencies to be used in the system are stored in the memory prior to the operation.

The amplifier operates for signal transmission while maintaining its output characteristic in which the power efficiency of the amplifier is maximized at a transmission frequency allocated to the telephone system within a predetermined band.

### BRIEF DESCRIPTION OF THE DRAWINGS

The above and further objects as well as features and advantages of the present invention will be more apparent from the following description, taken in conjunction with the accompanying drawings in which:
Fig. 1 is a block diagram illustrating a transmission section and a control section of a typical portable telephone system including a portable telephone system according to an embodiment of the present invention;
Fig. 2 is a schematic diagram illustrating an equivalent circuit of a final amplifying stage of a microwave amplifier used for a conventional portable telephone system.
Fig. 3 is a block diagram schematically showing a conventional portable telephone system including an impedance compensation circuit for a microwave amplifier;
Fig. 4 is a schematic diagram illustrating an equivalent circuit of a microwave amplifier of the portable telephone system of Fig. 1, according to the embodiment of the present invention; and
Fig. 5 is a graph illustrating an example of the output power characteristic vs frequency in a conventional portable telephone system for showing an advantage of the present invention.

### DESCRIPTION OF THE PREFERRED EMBODIMENTS

Before describing the embodiments of the present invention, the problems in the conventional microwave amplifiers will be described hereinafter for the sake of understanding of the present invention. In this text, the power efficiency of an amplifier is expressed by a ratio in percent of an output signal power thereof to a DC supply power supplied thereto.

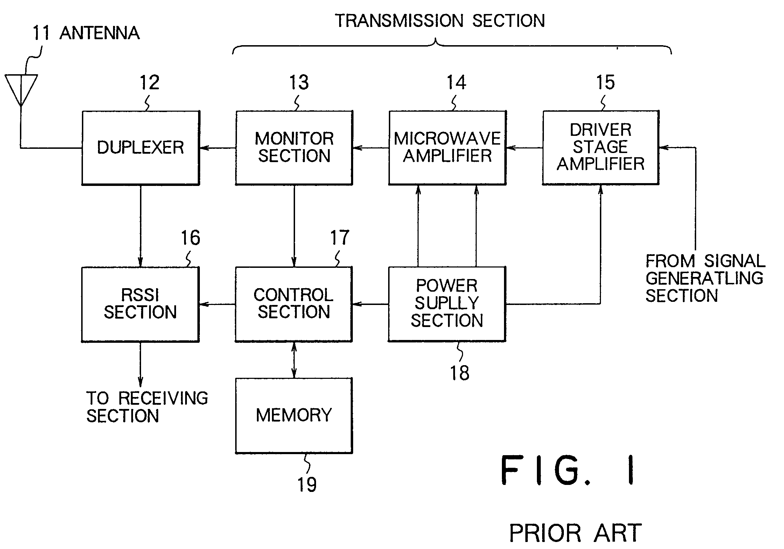

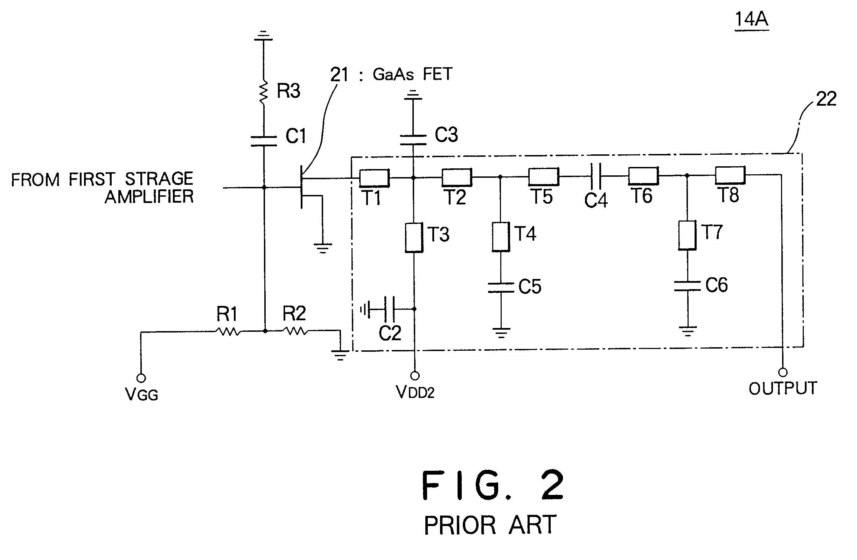

Fig. 1 is a block diagram of a partial construction of a typical portable telephone system illustrating a transmission section and a control section thereof, and Fig. 2 is a schematic diagram illustrating a portion of a conventional microwave amplifier 14A such as shown in Fig. 1. A portable telephone system generally comprises an antenna, a transmission section including a signal generating section, a receiving section and a control section. In Fig. 1, however, the signal generating section and the receiving section are not illustrated. In Fig. 2, the microwave amplifier 14A comprises a first stage amplifier not illustrated and a final stage amplifier including GaAsFET 21 and an impedance matching circuit 22 for the GaAsFET 21. In general, a microwave amplifier used in a portable telephone system has a highest efficiency among other current microwave amplifiers.

The microwave amplifier 14A has distributed constants and concentrated constants in combination which are implemented by microstrip conductors T1 to T8, chip capacitors C1 to C6, and chip resistors R1 to R3, all provided on a semi-insulating substrate designed for mounting parallel conductor transmission lines.

In the microwave amplifier 14A, the level of the input power, the drain bias voltage V_{DD1} of a GaAs FET in the first stage (not illustrated), and the drain bias voltage V_{DD2} and gate bias voltage V_{GG} of a GaAs FET 21 in the final stage as illustrated can be controlled from the outside. The portable telephone system comprising the microwave amplifier 14A has a so-called APC (Automatic Power Control) function which controls the output power of the system to one of several predetermined levels as described below.

In Fig. 1, the portable telephone system receives a signal from a base station not illustrated through the antenna 11 of the telephone system, then detects the strength of the received signal by an RSSI (Received Signal Strength Indicator) section 16. The data representing the distance between the base station and the portable telephone system is fed from the RSSI section 16 to a control section 17.

The control section 17 selects the level of output power of the system in accordance with the data fed from the RSSI section 16, then controls a power supply section 18 while monitorring the level of output power of the microwave amplifier 14 by a monitor section 13, whereby effecting an APC function. Typically, in a conventional portable telephone system, the APC function merely controls the drain bias voltage V_{DD1} of the first stage GaAs FET of the microwave amplifier 14, or simultaneously controls both the drain bias voltages V_{DD1} and V_{DD2} of the GaAsFET's in the first and the second stages of the microwave amplifier 14A in the same manner.

Alternatively, another method is employed for an APC function in a conventional portable telephone system, in which the level of input power applied to the microwave amplifier 14 is varied by changing the bias voltage of a driver stage amplifier 15 (Fig. 1), thereby effecting the APC function while maintaining the drain bias voltages V_{DD1} and V_{DD2} of the GaAsFET's of the microwave amplifier 14 being unchanged.

Typically, a portable telephone system operates in the state where the gate bias voltages V_{GG} supplied to the GaAsFET's of the microwave amplifier 14 is fixed. However, in a recent portable telephone system, the gate bias voltage V_{GG} is varied to a predetermined value depending on the level of APC function so that the idle current of the microwave amplifier 14 (current flowing through the amplifier 14 in the state where no microwave signal is input) is reduced to improve the power efficiency of the portable telephone system.

The portable telephone system comprises a filter, called a duplexer 12 as shown in Fig. 1, for effecting simultaneously both transmitting and receiving through the common antenna 11. For the transmission section of the telephone system as illustrated in Fig. 1, the duplexer 12 should have a steep frequency characteristic for passing a transmission signal having a first frequency (transmission frequency) allocated to the system while attenuating a received signal having a second frequency. Hence, it generally has an impedance which changes depending on the frequency of a signal passing therethrough. Since the impedance of the duplexer 12 also becomes a part of the load impedance for the final stage amplifier of the microwave amplifier 14, the microwave amplifier 14 has a load impedance varying in a significant extent even within the frequency band to be used for the system.

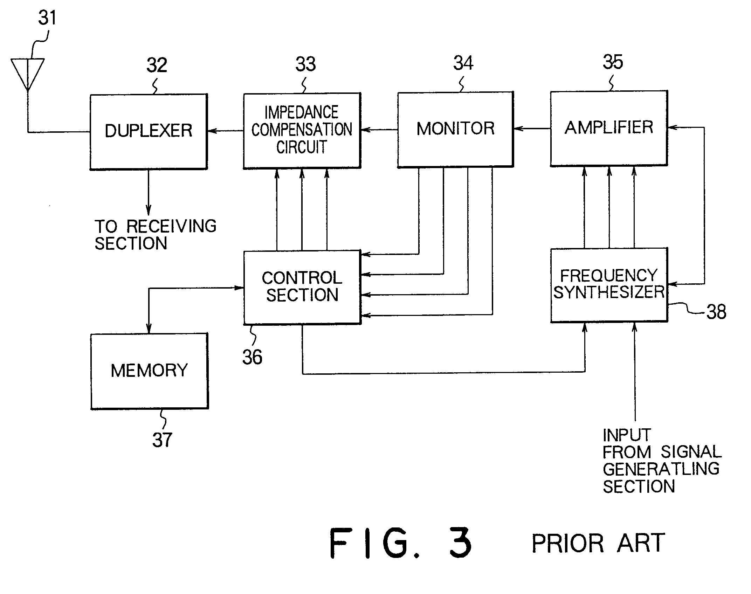

To obtain a constant load impedance for a final stage amplifier, Japanese Patent Laid-Open Publication No. 62-25507 describes a portable telephone system such as shown in Fig. 3, in which impedance matching function for the microwave amplifier 35 is effected to conform to changes in the transmission frequency. This system operates in a mode in which frequency hopping is effected in a "high frequency band" ranging from 1.6 MHz to 30 MHz, so that an antenna 31 does not have a constant predetermined impedance, for example 50 Ω, at transmission frequencies within the frequency band to be used in the system. A monitor section 34 monitors a signal transmitted by a transmission line in the telephone system to thereby measure the phase of the load for the transmission line, the resistance of the load, power on the transmission line and reflection of the signal, then transmits the data thereof to a control section 36.

The control section 36 controls an impedance compensation circuit 33 composed of a bank of inductances and capacitances to adjust the load impedance for the amplifier 35 close to 50 Ω. Data on a frequency and a corresponding impedance obtained by effecting the impedance matching operation thereto are written in a look-up table stored in a memory 37. When the same frequency is to be used again, the impedance corresponding thereto is read out from the look-up table in the memory 37, hence the impedance compensation circuit 33 is set at the impedance.

Namely, in a conventional portable telephone system described in the publication, the load impedance as viewed from the amplifying transistor of the amplifier 35 is controlled to be close to a predetermined impedance, for example 50 Ω, by variably adjusting the inductances and the capacitances of the impedance compensation circuit 33, when the impedance of the antenna 31 changes in accordance with changes in the frequency of the microwave signal. The impedance compensation circuit 33 is composed of a large bank of inductances and capacitances. To carry out such operations at a high speed, a memory device is generally provided for storing and reading out control data corresponding to desired frequencies.

In the impedance matching circuit described in the publication as mentioned above and having a capability of adjusting the load impedance in accordance with changes in frequency, however, the load impedance for the amplifier is controlled to be set at 50 Ω. Although losses caused by mismatching between the amplifier and the antenna can be reduced significantly in the system, improvement in the power efficiency of the amplifier itself cannot be expected, because the impedance matching function is controlled merely to maintain the VSWR (voltage standing-wave ratio) of the load of the amplifier in an allowable range.

In portable telephone systems, both a high power efficiency and a high output power exceeding a predetermined minimum level are regarded as most desirable characteristics of amplifiers of the telephone systems. The higher the power efficiency is, the longer period of time a communication can be continued under a limited power of a battery. A significant portion of the current supplied to a portable telephone system is consumed by its power amplifiers. Therefore, the amplifier of the portable telephone system is especially required to have a higher power efficiency.

Moreover, strict standards are imposed upon microwave amplifiers used in portable telephone systems regarding the level of harmonies of the fundamental frequency which are double, triple, and quadruple the fundamental frequency, and regarding the distortion characteristic, called transmission IM. When the load impedance for a microwave amplifier is varied, the harmonic components and the transmission IM will change. Accordingly, the harmonic characteristic and the transmission IM characteristic may be deteriorated when the impedance matching function is effected, as described in the publication, such that the VSWR of the load falls in an allowable range at only the fundamental frequency .

Since portable telephone systems use a 800-900 MHz band or a 1 GHz band in the current communication system, an impedance compensation circuit inserted between an amplifier and an antenna causes a drawback that a transmission loss is generated in the impedance compensation circuit itself. In addition, the construction of the impedance compensation circuit and a program for controlling the impedance compensation circuit are complicated resulting in an increase of the fabricating cost.

It has been considered that the actual use of the impedance compensation circuit is difficult in view of the fact that compactness, reduction of power consumption and reduction of costs are regarded as especially important factors in the field of portable telephone systems.

Now, embodiments of the present invention solving the problems as described above will be described below with reference to the drawings.

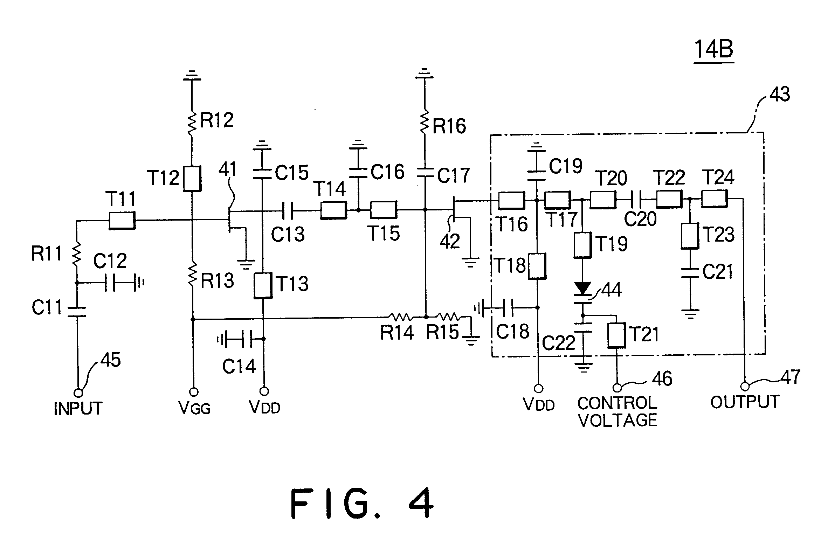

Fig. 4 is a schematic diagram showing an equivalent circuit of a microwave amplifier for amplifying a transmission signal in a portable telephone system according to an embodiment of the present invention. The portable telephone system is such as shown in Fig. 1.

In Fig. 4, the microwave amplifier 14B is composed of a GaAsFET 41 in a first stage amplifier for amplifying a microwave signal input from the signal generating section through an input terminal 45, a GaAs FET 42 in the final stage for amplifying the microwave signal fed by the first stage so as to feed its output through drain electrode thereof, and an impedance matching circuit 43 including a variable capacitance diode 44 providing a variable capacitive reactance component of the load impedance for the GaAsFET 42, the capacitive reactance component varying in accordance with changes in a DC control voltage supplied from the outside through a control terminal 46.

Although the variable-capacitance diode 44 is employed in this embodiment, basically any capacitive element having a variable capacitance varying in accordance with a control signal supplied from the outside can be used. Among Schottky diodes and FET's designed for microwave circuits, those offering a capacitance variation by about 7 pF may be preferably used.

When the amplifier 14B shown in Fig. 4 is included in an analog portable telephone system such as shown in Fig. 1 for use in AMPS (Advanced Mobile Phone Service) of North America, the various constants of the impedance matching circuit 43 are typically determined for the frequency 836.5 MHz which is approximate to the center of the transmission frequency band.

The impedance matching circuit 43 is optimally designed such that the optimal frequency at which the power efficiency of the amplifier 14B is maximized is obtained at a transmission frequency within the frequency band, by merely changing the capacitance of the variable capacitance diode 44, while suppressing harmonic distortions generated by the amplifier itself and suppressing the distortion in characteristics of the amplifier 14B such as a transmission IM.

In Fig. 4, the impedance matching circuit 43 comprises chip capacitors C18 to C21 and the variable-capacitor diode 44 interconnected by microstrip conductors or transmission lines T16 to T24. The drain electrode of GaAsFET 42 is connected through line T16 to the first electrode of capacitor C19, the second electrode of which is connected to the ground. The first electrode of the capacitor C19 is also connected through line T18 to a voltage source VDD, which is connected through capacitor C18 to the ground. The first electrode of capacitor C19 is further connected through lines T17 and T20 to the first electrode of capacitor C20, the second electrode of which is connected through lines T22 and T24 to an output terminal 47. A node connecting lines T17 and T20 is connected through line T19 to the anode of the diode 44, the cathode of which is connected through line T21 to a control terminal 46 and thorough capacitor C22 to the ground. Another node connecting lines T22 and T24 is connected through line T23 and capacitor C21 to the ground.

The microwave amplifier 14B basically operates in Class AB, yet such a circuit structure is employed which reduces the secondary and tertiary harmonics (called a "Class F" type). Since the output characteristic of the GaAs FET's 41 and 42 are nonlinear, harmonic components of the fundamental frequency are generated. In the present embodiment, impedance matching circuit 43 is formed for the final stage of the amplifier 14B such that, as viewed from the drain electrode of the FET 42 in the final stage, the impedance matching circuit 43 functions for passing the fundamental frequency substantially without distortion, but functions as a short circuit for the secondary harmonic and as an open circuit for the tertiary harmonic, thereby obtaining an output signal substantially composed of the fundamental frequency component alone.

The short circuit for the secondary harmonic is obtained by selecting the constants of microstrip conductor T23 and the capacitor C21, while the open circuit for the tertiary harmonic is obtained by selecting the constants of microstrip conductor T19, variable capacitance diode 44 and capacitance C22.

By substantially eliminating the harmonic components in the output of the microwave amplifier, the input DC power consumed for generating the output is decreased, so that an amplifier having a higher power efficiency can be obtained. In general, elimination or reduction of the secondary and tertiary harmonic components results in deterioration in band characteristic. In the present invention, however, a microwave amplifier having an improved band characteristic and a capability of suppressing secondary and tertiary harmonic components can be obtained merely by optimizing the circuit constants of the impedance matching circuit 43 and varying the capacitance of the variable-capacitance diode 44.

Now, a portable telephone system according to a second embodiment of the present invention will be described below, with reference to Fig. 1 again. In Fig. 1, there is shown a highly efficient microwave amplifier 14 having a variable-impedance matching circuit, such as shown in Fig. 4, in the portable telephone system.

In order to obtain a maximum power efficiency in a transmission frequency of AMPS, a DC voltage is supplied from outside the microwave amplifier 14 to determine the capacitance of the variable-capacitance diode. After the data is obtained for the DC control voltage applied in connection with a transmission frequency in an operation, the data is stored in a memory 19 for a subsequent operation. As the content of the data, a DC control voltage supplied in the previous operation may be stored correspondingly to the transmission frequency. For example, a certain DC voltage level is stored for a certain frequency such as 824 MHz. Alternatively, the frequency band to be used in the system may be divided into a plurality of sections, and a DC voltage level is stored for each of the divided sections. For example, a certain voltage level is stored for a certain section such as a 5 MHz-width frequency band from 824 to 829 MHz.

When the portable telephone system is turned on, it receives a signal from a base station. The signal received by the antenna 11 enters an RSSI section 16 through a duplexer 12. The RSSI section 16 detects the strength of the received signal, and outputs data representing the signal strength to the control section 17. Based on the data, the distance between the base station and the portable telephone system (mobile station) is judged, then the level of transmission power to be used in the portable telephone system is determined. In AMPS, for example, the output levels are categorized in seven groups.

In the portable telephone system according to the embodiment, a power supply section 18 determines the drain bias voltage V_{DD1} supplied to the first stage GaAsFET 41 (Fig. 4) of the microwave amplifier 14 or the bias voltage supplied to the amplifier 15 in a driver stage in order to control the output power of the system, while the power actually transmitted from the system is monitorred in the level thereof by a monitor section 13. This automatic control of the output power is what is called the APC function.

A communication is then effected between the portable telephone system and the base station. The base station allocates a transmission frequency (communication channel) to the portable telephone system. The data on the frequency thus allocated is fed from a signal processing section not illustrated in Fig. 1 to the control section 17, hence, a PLL synthesizer not illustrated is controlled based on the transmission frequency.

In a subsequent operation, when the same frequency as previously allocated is allocated to the telephone system, the same DC voltage previously supplied in connection with the same frequency is read out from the memory 19. The power supply circuit 18 is then controlled by the control section 17 and feed a DC control voltage to the variable-capacitance diode 43 of the microwave amplifier 14.

The characteristics of a portable telephone system of Fig. 1 having a microwave amplifier of Fig. 4 according to the embodiment was evaluated, with the input and output impedances thereof being set at 50 Ω. The results showed that the frequency at which the power efficiency reached a maximum varied from 820 MHz to 850 MHz when the capacitance of the variable-capacitance diode was changed from 2 pF to 6 pF. The capacitance is varied by controlling the reverse voltage applied to the cathode of the variable-capacitance diode from the outside. When the capacitance is fixed at 4 pF, for example, the power efficiency of the amplifier 14B reaches a maximum at about 64% in the vicinity of 835 MHz, while reaches a minimum at about 60% in the vicinity of 849 MHz within the frequency band from 824 MHz to 849 MHz.

When the capacitance of the diode 44 is fixed at 2 pF, the secondary harmonic of a fundamental frequency becomes the largest component among other harmonic components corresponding to the fundamental frequency. However, the level of the second harmonic is only -35 dB which is sufficiently below the limit thereof. When the capacitance is increased, the secondary harmonic component tends to decrease while the tertiary and the fourth order harmonics do not change.

Although the transmission IM characteristic tends to deteriorate as the capacitance of the diode 44 decreases, it is sufficiently below the limit thereof. After the data of the voltage applied to the cathode of the variable-capacitance diode is stored correspondingly to a transmission frequency used in the system, the data is read out in a subsequent operation using the same transmission frequency so that the impedance of the impedance matching circuit 43 is varied in accordance with the transmission frequency to be used in the operation. The operation is such that it maximizes the power efficiency of the amplifier 43 at any transmission frequency within the frequency band of the telephone system. It is effected by monitoring output power level of the microwave amplifier and power of the DC source supplied to the microwave amplifier and controlling the DC voltage supplied to the control terminal 46.

As described above, the impedance of the impedance matching circuit for the the microwave amplifier is varied by changing the DC voltage supplied from the outside in accordance with the transmission frequency to be used. Therefore, it is possible to operate the amplifier at a maximum efficiency at any transmission frequency. A change in transmission frequency usually occurs when the portable telephone system moves from an area of a certain base station to another area of a different base station. In this case, a new transmission frequency to be used is allocated by a process similar to the above. In the present embodiment, the data on the new frequency to which the transmission frequency is changed is input to the control section 17 prior to the signal transmission, resulting in that the amplifier can be operated in accordance with the frequency such that the power efficiency is maximized. The data thus obtained is stored in the memory for a subsequent operation.

The microwave amplifier according to the present invention can be applied to conventional portable telephone systems while maintaining the original configuration of the conventional portable telephone systems. In detail, in order to supply the microwave amplifier of the present invention to a conventional portable telephone system, it is sufficient to add a memory for storing data of the control voltages corresponding to frequencies and a control program in the telephone system. It does not cause a drastic increase in the number of parts or a complicated circuit, but only a memory of a small capacity is required because the amount of the data to be stored in the memory is not large.

In the case where a conventional microwave amplifier is replaced by the microwave amplifier according to the embodiment of the present invention in a portable telephone system, the increase of a transmission loss can be neglected because an impedance compensation section is not built inside the amplifier of the present embodiment.

Moreover, in the embodiment, the data of a frequency and control voltage to be stored in combination can be estimated in the state where the amplifier is assembled on an actual circuit board in place of setting the input and output impedances at a fixed impedance of, for example, 50 Ω. In this construction, it is possible to reduce the deviation of the output power from 2-3 dB in the conventional amplifier down to about 1 dB or less within the frequency band used in the portable telephone system. On the contrary, in a conventional APC function, the output power of a microwave amplifier is controlled such that the output power of the amplifier exceeds a predetermined minimum power level even at a frequency at which the output power of the amplifier becomes minimum. Accordingly, in a conventional amplifier, an excess output power exceeding the predetermined power level by the amount of maximum deviation is transmitted at a frequency at which the output power of the amplifier becomes a maximum. Since a trade-off relationship exists between a sufficient output power and a reduction of the current consumption in an amplifier, the current consumption increases by an amount corresponding to an increase of the excessive portion of the output power.

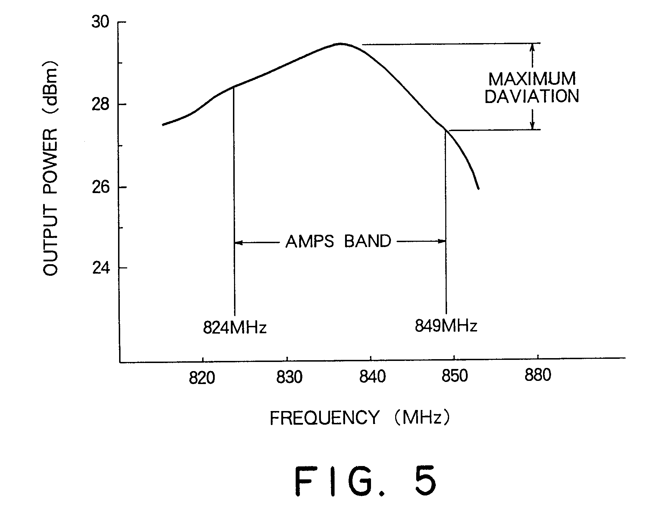

Fig. 5 is a graph showing an output power vs transmission frequency in a conventional portable telephone system such as shown in Fig. 1 used for AMPS in North America. In the drawing, the deviation in output power in the conventional amplifier is caused by the frequency characteristic of the output power of the microwave amplifier 14 itself, the frequency characteristic on power loss produced at the duplexer 12, and impedance mismatching between the microwave amplifier 14 and the duplexer 12.

As shown in Fig. 5, when the conventional amplifier is applied to an actual portable telephone system, a deviation of about 2 to 3 dB is generated in the output power of the portable telephone system within the frequency band to be used in the telephone system. The output level is controlled by the APC function such that, when an output deviation is generated within the frequency band, a predetermined output level is obtained at a frequency within the frequency band at which the output power becomes a minimum. This generates excess power at other frequencies, resulting in an increase of the power consumption of the portable telephone system.

Since the use of the microwave amplifier according to the present invention substantially eliminates the deviation of the output power of the amplifier itself within the frequency band to be used and substantially eliminates mismatching of the impedance at the output of the amplifier, the deviation of the output power of the portable telephone system is substantially determined by the power loss at the duplexer 12.

Namely, if the amplifier according to the present invention is applied to a portable telephone system, the amplifier operates such that its efficiency is maximized at a transmission frequency to be used at that time. Therefore, the deviation of the output power within the frequency band is reduced from a 2-3 dB level in conventional portable telephone systems to a level equal to or less than 1 dB, because the power consumption is decreased by an amount corresponding to the excessive portion of the output power. As a result, the power consumption can be reduced by about 30 mA, for example, at a frequency so that the power efficiency is improved by about 3%. Accordingly, the power efficiency of the portable telephone system can be improved without increasing the number of circuit parts thereof very much.

As describe above, in the microwave amplifier according to the embodiment, the impedance of the impedance matching circuit can be controlled by changing a DC voltage supplied From the outside so that the impedance is varied to maximize the power efficiency of the amplifier in accordance with a transmission frequency to be used, whereby an advantage of a flat characteristic can be obtained within the frequency band of the microwave amplifier.

Further, since the microwave amplifier according to the embodiment has an optimized circuit structure and circuit constants, it has the advantage that increase in the levels of harmonic components and deterioration of the transmission IM characteristic do not occur even when the impedance of the impedance matching circuit is varied frequency by frequency to be used.

Especially, when the present invention is applied to microwave amplifiers used for AMPS in North America, the power efficiency measured within the frequency band of the amplifier varies only in the range of 64-63% at frequencies ranging from 824 to 849 MHz, resulting in that the deviation of the efficiency within the band can be reduced to equal to or below about 1%, while, in the conventional system, the power efficiency varied in the range of 64-60% at the same condition, resulting in 4% deviation within the frequency band.

Also, when the present invention is applied to portable telephone systems used for AMPS in North America, deterioration of the characteristic caused by a deviation of the impedance from that of an actual system can be reduced, so that the deviation of the efficiency within the band can be reduced from about 5-10% in the conventional level to a level of about 2-3%.

Moreover, the amplifier according to the present invention can be used as it is for replacement of microwave amplifiers used in conventional portable telephone systems. Since the variable-impedance component is built inside the microwave amplifier, an increase in the transmission loss can be mostly neglected. Further, the present invention has the advantage that it can achieve an increase of power efficiency and a reduction of power consumption to prolong the continuous communication period of time, while avoiding an increase in number of hardware parts in the portable telephone system.

Although the present invention is described with reference to the preferred embodiments, the present invention is not limited to such embodiments and it will be obvious for those skilled in the art that various modifications or alterations can be easily made based on the above embodiments within the scope of the present invention.

## Claims

1. A microwave amplifier comprising an amplifying means (42) for amplifying a microwave signal, an impedance matching circuit (43) having a variable impedance (44) operatively connected to the output of said amplifying means (42), characterized in that the impedance of said variable impedance (44) is controlled from outside in accordance with the frequency of the microwave signal.

2. A microwave amplifier as defined in Claim 1 wherein the impedance of said variable impedance (44) is controlled such that said microwave amplifier operates in a maximum power efficiency.

3. A microwave amplifier as defined in Claim 1 wherein said impedance matching circuit includes a variable capacitor (44).

4. A microwave amplifier as defined in Claim 3 wherein said variable capacitor is implemented by a diode (44) having a cathode receiving said control signal.

5. A microwave amplifier as defined in Claim 1 wherein said impedance matching circuit acts as a short circuit for second harmonic of the frequency of the microwave signal.

6. A microwave amplifier as defined in Claim 1 wherein said impedance matching circuit acts as an open circuit for tertiary harmonic of the frequency of the microwave signal.

7. A portable telephone system comprising: a signal generating section for generating a microwave signal having a frequency within a predetermined frequency band; an amplifier (14) for amplifying the microwave signal; an impedance matching circuit operatively connected to the output of said amplifier and having a variable impedance; and a control section (17) for selecting the frequency of the microwave signal: characterized in that the impedance of said variable impedance is controlled in accordance with the frequency selected by the control section (17).

8. A portable telephone system as defined in Claim 7 wherein said control section (17) includes a memory (37) for storing a look-up table having data representing a plurality of frequencies within the frequency band and a plurality of variable impedances each to be selected corresponding to one of the plurality of the frequencies.

9. A portable telephone system as defined in Claim 7 wherein the impedance of said variable impedance (44) is determined such that the impedance matching circuit provides a maximum power efficiency at the corresponding one of the plurality of frequencies.

10. A portable telephone system as defined in Claim 9 wherein the deviation of the power efficiency within the predetermined frequency band is not more than about 1 dB.
